# EUROPEAN PATENT SPECIFICATION

(11) **EP 3 815 144 B1**
(45) Date of publication and mention of the grant of the patent: **13.03.2024**
(21) Application number: 19859349.3
(22) Date of filing: 20.08.2019
(51) Int. Cl.: H01L 27/15, H01L 33/56, H01L 33/54, H01L 33/36, H01L 33/62, H01L 25/075

(54) **MANUFACTURING METHOD OF A DISPLAY APPARATUS**
HERSTELLUNGSVERFAHREN FÜR EINE ANZEIGEVORRICHTUNG
PROCÉDÉ DE FABRICATION D'UN APPAREIL D'AFFICHAGE

(30) Priority: 10.09.2018 KR 20180107686
(43) Date of publication of application: 05.05.2021
(73) Proprietor: Samsung Electronics Co., Ltd., Suwon-si 16677 (KR)
(72) Inventor: LEE, Tack Mo, Suwon-si Gyeonggi-do 16677 (KR); YOON, Jung-Hoon, Suwon-si Gyeonggi-do 16677 (KR); KIM, Gi Tae, Suwon-si Gyeonggi-do 16677 (KR); LEE, Won Yong, Suwon-si Gyeonggi-do 16677 (KR); PARK, Won Soon, Suwon-si Gyeonggi-do 16677 (KR)
(74) Representative: Walaski, Jan Filip
(86) International application number: PCT/KR2019/010527
(87) International publication number: WO 2020/054992

(56) References cited:
- WO-A1-2016/032167
- WO-A1-2018/140417
- CN-A- 103 943 617
- KR-A- 20140 082 088
- KR-A- 20180 067 447
- US-A1- 2017 092 820
- US-A1- 2017 338 212
- US-A1- 2017 359 865

## Description

### Technical Field

The disclosure relates to a display apparatus and a manufacturing method thereof, and, more particularly, to a display apparatus in which an inorganic light emitting diode is directly mounted on a substrate, and a manufacturing method thereof.

### Background Art

A display apparatus is a kind of an output device that visually displays data information such as characters and figures, and images, and the demand for high luminance, high resolution, large size, high efficiency, and low power display apparatuses is continuously increasing. Accordingly, an Organic Light Emitting Diode (OLED) panel has been popular as a new display apparatus that replaces a Liquid Crystal Display (LCD), but the OLED has some difficulties to be solved such as the high price caused by a low production yield rate, securing the reliability of large size panel, and securing the durability that is affected by external environment such as moisture. US 2017/359856 A1 relates to a method of forming an LED display device including a coating layer that surrounds LED elements.

As a new product that replaces or supplements the LCD panel and the OLED panel, a study of a new technology for manufacturing a panel by directly mounting an inorganic light emitting diode emitting red (R), green (G) and blue (B) light, on a substrate has been conducted. The inorganic light emitting display technology has many difficulties in transferring an inorganic light emitting diode having a size of several micrometers to several hundreds of micrometers from a wafer to a substrate. However, even after the inorganic light emitting diode is mounted on a substrate, there are still difficulties in physically protecting the inorganic light emitting diode without the optical distortion and the optical loss. Further, there is a need for a technology that can improve image quality in addition to a technology for simply protecting the inorganic light emitting diode.

### Disclosure of Invention

### Technical Problem

It is an aspect of the present disclosure, not forming part of the claimed invention, to provide a display apparatus including an improved structure capable of improving bonding reliability of inorganic light emitting diodes and capable of reducing a speckle noise caused by inorganic light emitting diodes mounted on a substrate in a tilted state. According to the claimed invention, a manufacturing method thereof is provided.

It is another aspect of the present disclosure, not forming part of the claimed invention, to provide a display apparatus including an improved structure capable of reducing right and left viewing angles and capable of preventing a seam between unit modules adjacent to each other from being seen. According to the claimed invention, a manufacturing method thereof is provided.

### Technical Solution

According to the invention, a manufacturing method of a display device is provided as set out in claim Further preferred embodiments of the invention are defined in the dependent claims.

### Advantageous Effects of Invention

By arranging the black molding layer having the low refractive index on the substrate to surround the inorganic light emitting diode, it is possible to improve the bonding reliability of the inorganic light emitting diode and to effectively reduce the speckle noise.

When the black molding layer is formed to surround the side surface of the inorganic light emitting diode, light generated from the inorganic light emitting diode may be blocked by the black molding layer and thus it is difficult for the light to be emitted to the outside of the display apparatus through the side surface of the inorganic light emitting diode. Therefore, it is possible to expect an effect of reducing the right and left viewing angles of the display apparatus, and it is possible to effectively prevent the seam between the unit modules adjacent to each other, from being seen.

### Brief Description of Drawings

FIG. 1 is a perspective view of a display apparatus according to an embodiment of the disclosure, not forming part of the claimed invention;
FIG. 2 is a front view illustrating a state in which a plurality of unit modules are arranged in a matrix according to an embodiment of the disclosure, not forming part of the claimed invention;
FIG. 3 is a front view of a single unit module according to an embodiment of the disclosure, not forming part of the claimed invention;
FIG. 4 is a flow chart illustrating a first manufacturing method of the display apparatus according to an embodiment of the invention;
FIGS. 5A to 5E are views illustrating a manufacturing process according to the first manufacturing method of FIG. 4;
FIG. 6 is a flow chart illustrating a second manufacturing method of the display apparatus according to an embodiment of the invention;
FIGS. 7A to 7E are views illustrating a manufacturing process according to the second manufacturing method of FIG. 6;
FIG. 8 is a flow chart illustrating a third manufacturing method of the display apparatus according to an embodiment of the invention;
FIGS. 9A to 9D are views illustrating a manufacturing process according to the third manufacturing method of FIG. 8;
FIG. 10 is a flow chart illustrating a fourth manufacturing method of the display apparatus according to an embodiment of the invention; and
FIGS. 11A to 11D are views illustrating a manufacturing process according to the fourth manufacturing method of FIG. 10.

### Best Mode for Carrying out the Invention

Hereinafter, embodiments of the disclosure will be described with reference to drawings. In the following detailed description, the terms of "front end", "rear end", "upper portion", "lower portion", "upper end", "lower end" and the like may be defined by the drawings, but the shape and the location of the component is not limited by the term.

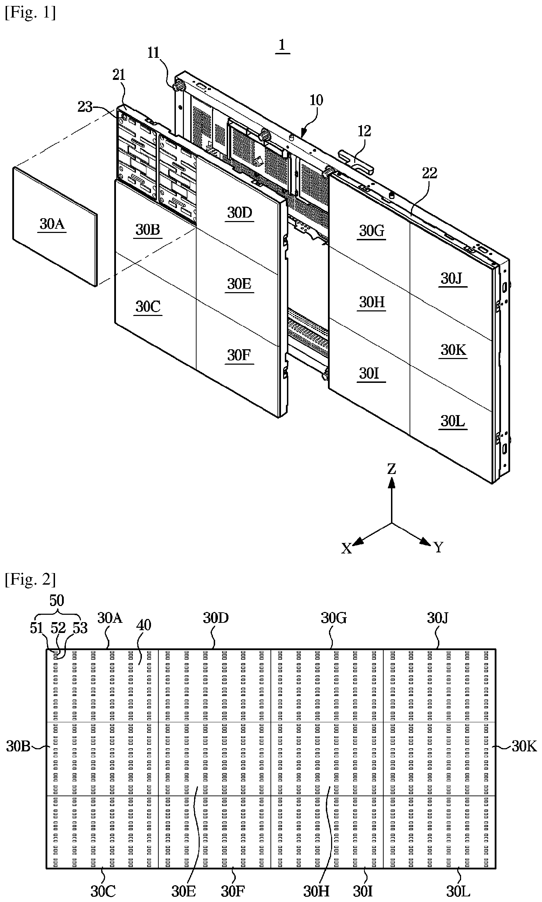

FIG. 1 is a perspective view of a display apparatus according to an embodiment of the disclosure. In FIG. 1, "X" represents a front and rear direction, "Y" represents a left and right direction, and "Z" represents an up and down direction.

Referring to FIG. 1, a display apparatus 1 is a device for displaying information, materials, and data as the form of characters, features, graphics, and image, and a television (TV), a personal computer (PC), a mobile, and a digital signage may be implemented by the display apparatus 1. The display apparatus 1 may be installed on the ground by a stand (not shown) or may be installed on a wall.

According to an embodiment, the display apparatus 1 may include a cabinet 10, a plurality of unit modules 30A~30L installed in the cabinet 10, and frames 21 and 22 connecting the cabinet 10 to the plurality of unit modules 30A~30L. The cabinet 10 may support the plurality of unit modules 30A~30L and form a part of an outer appearance of the display apparatus 1. The cabinet 10 may be provided with a handle 12 for movement.

The plurality of unit modules 30A~30L may be arranged in an M * N matrix in the up, down, left, and right directions so as to be adjacent to each other. According to an embodiment, the plurality of unit modules 30A~30L may be formed in such a way that 12 unit modules are coupled to the cabinet 10 in the form of a 4 * 3 matrix, but the number and arrangement of a plurality of unit modules are not limited thereto. Some unit modules 30A~30F of the plurality of unit modules 30A~30L may be installed in the cabinet 10 via the frame 21, and remaining unit modules 30G~30L may be installed in the cabinet 10 via the other frame 22.

The cabinet 10 and the frames 21 and 22 may be provided with a cabinet coupling portion 11 and a frame coupling portion 23, respectively so that the unit modules 30A~30L are installed in the cabinet 10. The cabinet coupling portion 11 and the frame coupling portion 23 may be coupled to each other through various known methods such as a magnetic force using a magnet or a mechanical fitting structure.

The display apparatus 1 may further include a control board (not shown) for driving the plurality of unit modules 30A~30L and a power supply device (not shown) for supplying power to the plurality of unit modules 30A~30L.

The unit modules 30A~30L may be planar or curved. Furthermore, the curvature thereof may vary.

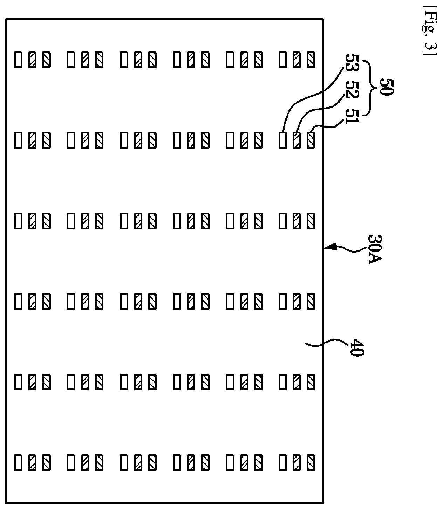

FIG. 2 is a front view illustrating a state in which a plurality of unit modules are arranged in a matrix according to an embodiment of the disclosure. FIG. 3 is a front view of a single unit module according to an embodiment of the disclosure.

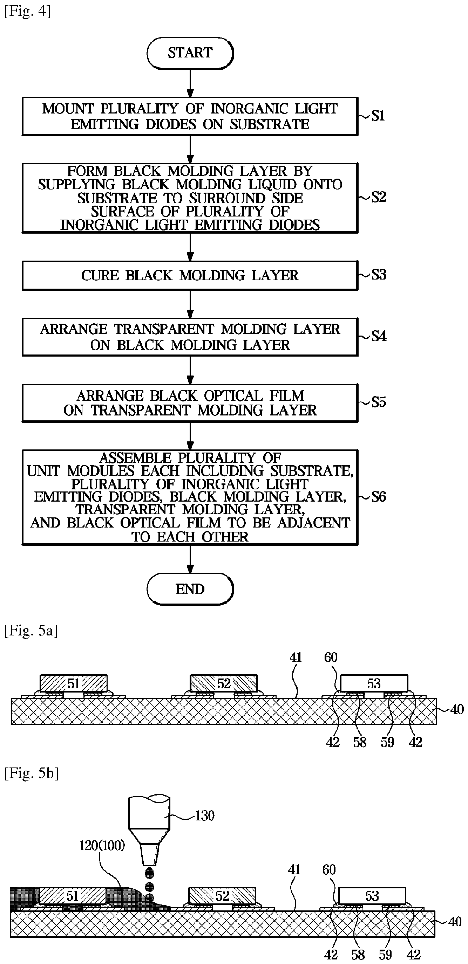

As illustrated in FIGS. 2 and 3, the unit modules 30A~30L each may include a substrate 40 and a plurality of inorganic light emitting diodes 50 mounted on a mounting surface 41 (see, FIG. 5A) of the substrate 40. Each of the plurality of inorganic light emitting diodes 50 may include a p-n diode, a first contact electrode 58 (see, FIG. 5A), and a second contact electrode 59 (see, FIG. 5A).

The substrate 40 may be formed of a material such as polyimide (PI), FR4, and glass. On the mounting surface 41 of the substrate 40, a pattern for forming a driving circuit, and electrodes 42 (see, FIG. 5A) may be formed. The first contact electrode 58 and the second contact electrode 59 of the plurality of inorganic light emitting diodes 50 may be soldered to the electrodes 42 formed on the substrate 40.

The inorganic light emitting diode 50 may be formed of an inorganic material. Therefore, the inorganic light emitting diode 50 may have higher durability and a longer lifetime than the organic light emitting diode (OLED), which is based on organic materials, and the inorganic light emitting diode 50 may have the power efficiency several times higher than that of the OLED. The inorganic light emitting diode 50 may include LED.

The plurality of inorganic light emitting diodes 50 may include a red inorganic light emitting diode 51, a green inorganic light emitting diode 52, and a blue inorganic light emitting diode 53. The plurality of inorganic light emitting diodes 50 may be formed by mounting a series of the red inorganic light emitting diode 51, the green inorganic light emitting diode 52 and the blue inorganic light emitting diode 53 as a unit, on the substrate 40. The red inorganic light emitting diode 51, the green inorganic light emitting diode 52 and the blue inorganic light emitting diode 53 may form a single pixel.

The red inorganic light emitting diode 51, the green inorganic light emitting diode 52 and the blue inorganic light emitting diode 53 may be arranged at a predetermined interval in a row as illustrated in the drawings, but it may be arranged in the other forms.

The plurality of inorganic light emitting diodes 50 may be picked up from a wafer and transferred directly onto the substrate 40. The plurality of inorganic light emitting diodes 50 may be picked up and transferred through an electrostatic method using an electrostatic head or a bonding method using an elastic polymer such as PDMS or silicon as a head. A width, a length, and a height of the plurality of inorganic light emitting diodes 50 each may have a size of several micrometers to several hundreds of micrometers.

The plurality of inorganic light emitting diodes 50 may be formed in the form of a flip chip in which the first contact electrode 58 and the second contact electrode 59 are arranged in the same direction. The first and second contact electrodes 58 and 59 of the plurality of inorganic light emitting diodes 50 may be connected to the electrodes 42 of the substrate 40 through soldering.

FIG. 4 is a flow chart illustrating a first manufacturing method of the display apparatus according to an embodiment of the invention. Hereinafter, the first manufacturing method will be described with reference to FIGS. 5A-5E.

As illustrated in FIG. 4, a manufacturing method of the display apparatus 1 includes may mounting the plurality of inorganic light emitting diodes 50 on the substrate 40 (S1). In this case, the first contact electrode 58 and the second contact electrode 59 of the plurality of inorganic light emitting diodes 50 may be connected to the electrodes 42 of the substrate 40 through soldering.

The manufacturing method of the display apparatus 1 further includes forming a black molding layer 100 by supplying a black molding liquid 120 onto the substrate 40 so as to surround side surfaces 50b of the plurality of inorganic light emitting diodes 50 (S2).

The manufacturing method of the display apparatus 1 further includes curing the black molding layer 100 (S3).

The manufacturing method of the display apparatus 1 further includes arranging a transparent molding layer 200 on the black molding layer 100 (S4).

The manufacturing method of the display apparatus 1 further includes arranging a black optical film 300 on the transparent molding layer 200 (S5).

The manufacturing method of the display apparatus 1 further includes assembling the plurality of unit modules 30A-30L each including the substrate 40, the plurality of inorganic light emitting diodes 50, the black molding layer 100, the transparent molding layer 200, and the black optical film 300 to be adjacent to each other (S6).

Hereinafter, the first manufacturing method of the display apparatus 1 will be described in detail.

FIGS. 5A to 5E are views illustrating a manufacturing process according to the first manufacturing method of FIG. 4. Hereinafter, for convenience of description, a state in which the red inorganic light emitting diode 51, the green inorganic light emitting diode 52, and the blue inorganic light emitting diode 53 are mounted on the substrate 40 will be mainly described. Hereinafter, a drawing illustrating of assembling the plurality of unit modules 30A-30L to each other will be omitted.

As illustrated in FIG. 5A, the plurality of inorganic light emitting diodes 50 is mounted on the substrate 40. The plurality of inorganic light emitting diodes 50 is mounted on the mounting surface 41 of the substrate 40 to be spaced apart from each other at a predetermined distance. The first contact electrode 58 and the second contact electrode 59 of the plurality of inorganic light emitting diodes 50 may be connected to the electrodes 42 formed on the substrate 40 by a solder 60.

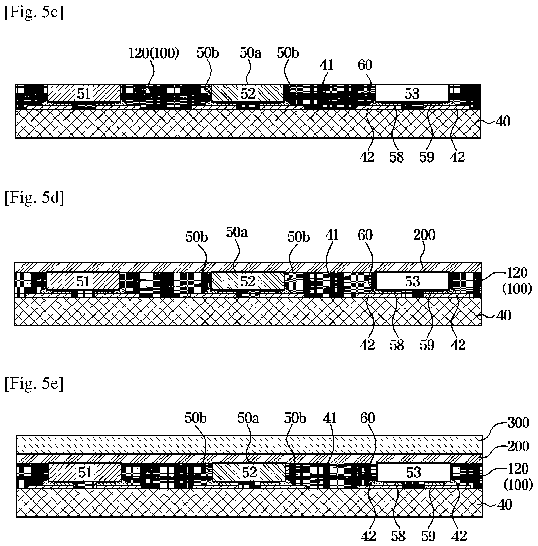

As illustrated in FIGS. 5B and 5C, the black molding layer 100 is formed to surround the plurality of inorganic light emitting diodes 50 on the substrate 40. The black molding layer 100 is formed on the substrate 40 to surround the side surfaces 50b of the plurality of inorganic light emitting diodes 50. In other words, the black molding layer 100 is formed on the substrate 40 in such a way that front light emitting surfaces 50a of the plurality of inorganic light emitting diodes 50 directed the front of the display apparatus 1 are exposed. That is, the black molding layer 100 is formed to surround the side surfaces 50b of the plurality of inorganic light emitting diodes 50, except for the front light emitting surfaces 50a of the plurality of inorganic light emitting diodes 50.

As illustrated in FIG. 5B, the black molding liquid 120 is supplied to the substrate 40 to form the black molding layer 100. The black molding liquid 120 may be applied, coated, or jetted onto the substrate 40 by a molding liquid supplier 130. The black molding liquid 120 may be printed on the substrate 40 by the molding liquid supplier 130. A method in which the black molding liquid 120 is supplied to the substrate 40 is not limited to the above example and thus the method may vary.

As illustrated in FIG. 5C, the black molded layer 100 is formed on the substrate 40 in such a way that the black molded layer 100 covers other surfaces of the plurality of inorganic light emitting diodes 50, except for the front light emitting surfaces 50a of the plurality of inorganic light emitting diodes 50, and then the black molded layer 100 is cured. For example, the black molding layer 100 may be cured by at least one of thermal curing and UV curing.

As illustrated in FIG. 5D, the transparent molding layer 200 is arranged on the black molded layer 100 to protect the plurality of inorganic light emitting diodes 50. The transparent molding layer 200 is disposed on the black molding layer 100 to physically protect the plurality of inorganic light emitting diodes 50 without optical distortion. As an example, the transparent molding layer 200 may be formed of a transparent material such as epoxy or silicone.

As illustrated in FIG. 5E, the black optical film 300 is disposed on the transparent molding layer 200 to improve optical characteristics of the plurality of inorganic light emitting diodes 50. The black optical film 300 is arranged to maintain the black impression and to lower the reflectance when the display apparatus 1 is turned off. The black optical film 300 includes a neutral density (ND) film), a circularly polarizing film, and a film capable of exhibiting the black impression by using a liquid coating.

The black molding layer 100 has a low refractive index. The black molding layer 100 has a refractive index of 1.40 or more and 1.58 or less. For example, when the black molding layer 100 is formed of an epoxy material, the black molding layer 100 may have a refractive index of 1.50 or more and 1.58 or less. The black molding layer 100 may have a refractive index of 1.50 or more and 1.51 or less when the black molding layer 100 is formed of an epoxy material. As another example, when the black molding layer 100 is formed of a silicon material, the black molding layer 100 may have a refractive index of 1.40 or more and 1.58 or less. The black molding layer 100 has a refractive index of 1.40 or more and 1.51 or less when the black molding layer 100 is formed of a silicon material.

The black molding layer 100 may include a base material and a black pigment. The base material may include at least one of a thermosetting material and a photosensitive material. As an example, the thermosetting material may include at least one of silicon, epoxy, ethylene-vinyl acetate copolymer (EVA), polyvinyl butyral (PVB) or urethane. As an example, the photosensitive material may include a photosensitive material capable of utilizing a photolithography process.

The black molding layer 100 may be implemented by a liquid or solid material. The black molding liquid 120 described in FIGS. 5A to 5E illustrates an example of the liquid material for forming the black molding layer 100. Alternatively, the black molding layer 100 may be implemented by a material in the form of a film. However, the material of the black molding layer 100 is not limited thereto and thus the material of the black molding layer 100 may vary.

As described above, when the side surfaces 50b of the plurality of inorganic light emitting diodes 50 are covered with the black molding layer 100 having a low refractive index, it is possible to effectively reduce a speckle noise caused by the tilting of the plurality of inorganic light emitting diodes 50. The speckle noise is a phenomenon in which a screen of the display apparatus appears to be shiny according to an angle. For example, in a state in which the side surfaces 50b of the plurality of inorganic light emitting diodes 50 are surrounded by the black molding layer having a refractive index of 1.48, the light may be emitted to the outside of the display apparatus and thus the speckle noise may occur when the plurality of inorganic light emitting diodes 50 are tilted. On the other hand, in a state in which the side surfaces 50b of the plurality of inorganic light emitting diodes 50 are surrounded by the black molding layer having a refractive index of 1.58, the light may be not emitted to the outside of the display apparatus and thus the speckle noise may not occur although the plurality of inorganic light emitting diodes 50 are tilted.

When the side surfaces 50b of the plurality of inorganic light emitting diodes 50 are covered with the black molding layer 100, light emitting regions of the plurality of inorganic light emitting diodes 50 may be changed from a rear end portion of the plurality of inorganic light emitting diodes 50 to a front end portion of the plurality of inorganic light emitting diodes 50. That is, when the side surfaces 50b of the plurality of inorganic light emitting diodes 50 are covered with the black molding layer 100, the light generated from the plurality of inorganic light emitting diodes 50 may be blocked by the black molding layer 100, and thus the light may be not emitted to the outside of the display apparatus 1 through the side surfaces 50b of the plurality of inorganic light emitting diodes 50. Therefore, the light may be emitted to the outside of the display apparatus 1 through the front light emitting surface 50a of the plurality of inorganic light emitting diodes 50. Accordingly, the right and left viewing angles may be reduced and the seam between adjacent unit modules may be prevented from being seen.

When the solder 60 is also formed to have a black color like the black molding layer 100, it is possible to maintain the black impression in an off state of the display apparatus 1 and to expect the improvement of the image quality contrast ratio in an on state of the display apparatus 1.

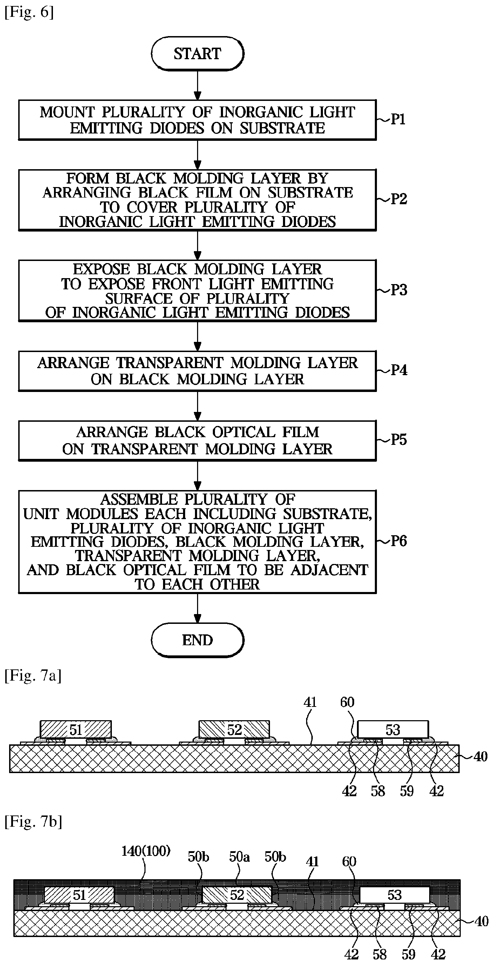

FIG. 6 is a flow chart illustrating a second manufacturing method of the display apparatus according to an embodiment of the invention. Hereinafter, the second manufacturing method will be described with reference to FIGS. 7A to 7E.

As illustrated in FIG. 6, a manufacturing method of the display apparatus 1 includes mounting the plurality of inorganic light emitting diodes 50 on the substrate 40 (P1). In this case, the first contact electrode 58 and the second contact electrode 59 of the plurality of inorganic light emitting diodes 50 may be connected to the electrodes 42 of the substrate 40 through soldering.

The manufacturing method of the display apparatus 1 further includes forming the black molding layer 100 by arranging a black film 140 on the substrate 40 to cover the plurality of inorganic light emitting diodes 50 (P2). In this case, the black film 140 may be laminated on the substrate 40 to cover both the front light emitting surfaces 50a and the side surfaces 50b of the plurality of inorganic light emitting diodes 50.

The manufacturing method of the display apparatus 1 further includes allowing the black molding layer 100 to be exposed to light such that the front light emitting surfaces 50a of the plurality of inorganic light emitting diodes 50 are exposed to outside (P3). The manufacturing method of the display apparatus 1 further includes exposing and developing the black molding layer 100 so that the front light emitting surfaces 50a of the plurality of inorganic light emitting diodes 50 are exposed.

The manufacturing method of the display apparatus 1 further includes arranging the transparent molding layer 200 on the black molding layer 100 (P4).

The manufacturing method of the display apparatus 1 further includes arranging the black optical film 300 on the transparent molding layer 200 (P5).

The manufacturing method of the display apparatus 1 further includes assembling the plurality of unit modules 30A-30L each including the substrate 40, the plurality of inorganic light emitting diodes 50, the black molding layer 100, the transparent molding layer 200, and the black optical film 300 to be adjacent to each other (P6).

Hereinafter, the second manufacturing method of the display apparatus 1 will be described in detail.

FIGS. 7A to 7E are views illustrating a manufacturing process according to the second manufacturing method of FIG. 6. Hereinafter, description of the same as the first manufacturing method of the display apparatus 1 will be omitted. Hereinafter, the drawing of assembling the plurality of unit modules 30A-30L together will be omitted.

As illustrated in FIG. 7A, the plurality of inorganic light emitting diodes 50 are mounted on the substrate 40. A description thereof is the same as those shown in FIG. 5A and thus it will be omitted.

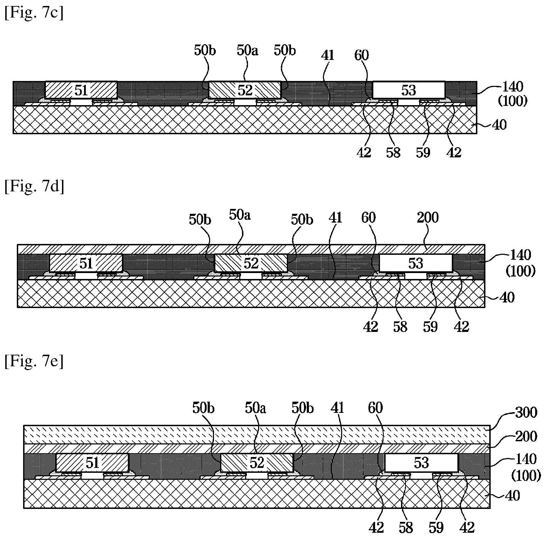

As illustrated in FIGS. 7B and 7C, the black molding layer 100 is formed on the substrate 40 to cover the plurality of inorganic light emitting diodes 50. The black molding layer 100 may be formed on the substrate 40 to completely cover the plurality of inorganic light emitting diodes 50, that is, the black molding layer 100 may be formed on the substrate 40 to surround both of the front light emitting surfaces 50a and the side surfaces 50b of the plurality of inorganic light emitting diodes 50.

As illustrated in FIG. 7B, the black molding layer 100 may be implemented in the form of the black film 140. The black film 140 may be disposed on the substrate 40 to cover the plurality of inorganic light emitting diodes 50. At this time, the light generated from the plurality of inorganic light emitting diodes 50 is blocked by the black film 140 covering the four sides of the plurality of inorganic light emitting diodes 50, and thus the light may be not emitted to the outside of the display apparatus 1.

As illustrated in FIG. 7C, the black film 140 is exposed so that the front light emitting surfaces 50a of the plurality of inorganic light emitting diodes 50 are exposed, and thus the black molding layer 100 may be formed through an exposure operation and a development operation. At this time, the light generated from the plurality of inorganic light emitting diodes 50 is emitted to the outside of the display apparatus 1 through the front light emitting surfaces 50a of the plurality of inorganic light emitting diodes 50.

As illustrated in FIG. 7D, the transparent molding layer 200 is arranged on the black molding layer 100 to protect the plurality of inorganic light emitting diodes 50. A description thereof is the same as those shown in FIG. 5D and thus it will be omitted.

As illustrated in FIG. 7E, the black optical film 300 is disposed on the transparent molding layer 200 to improve the optical characteristics of the plurality of inorganic light emitting diodes 50. A description thereof is the same as those shown in FIG. 5E and thus it will be omitted.

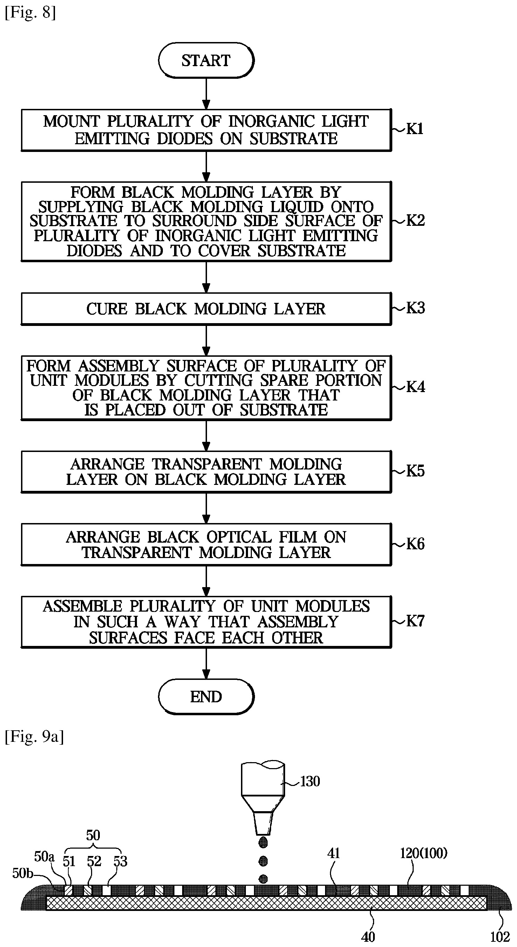

FIG. 8 is a flow chart illustrating a third manufacturing method of the display apparatus according to an embodiment of the invention and FIGS. 9A to 9D are views illustrating a manufacturing process according to the third manufacturing method of FIG. 8. The third manufacturing method of the display apparatus 1 is a method of manufacturing the display apparatus 1 by assembling a plurality of unit modules 30A-30L manufactured by the first manufacturing method of the display apparatus 1. Hereinafter, for convenience of description, the plurality of unit modules 30A-30L manufactured by the first manufacturing method of the display apparatus 1 will be mainly described, but alternatively may be manufactured by the second manufacturing method of the display apparatus 1. Hereinafter, FIGS. 1 to 5E may be referred to for reference numerals not shown in FIGS. 9A to 9D. Hereinafter, a case where the unit module 30A and the unit module 30D are assembled will be described as an example.

As illustrated in FIG. 8, a manufacturing method of the display apparatus 1 includes mounting the plurality of inorganic light emitting diodes 50 on the substrate 40 (K1). In this case, the first contact electrode 58 and the second contact electrode 59 of the plurality of inorganic light emitting diodes 50 may be connected to the electrodes 42 of the substrate 40 through soldering.

As illustrated in FIGS. 8 and 9A, the manufacturing method of the display apparatus 1 further includes forming the black molding layer 100 by supplying the black molding liquid 120 onto the substrate 40 so as to surround the side surfaces 50b of the plurality of inorganic light emitting diodes 50 (K2). The black molding liquid 120 may be supplied on the substrate 40 to overflow. That is, the black molding liquid 120 may be supplied on the substrate 40 sufficiently to overflow from the substrate 40.

The manufacturing method of the display apparatus 1 further includes curing the black molding layer 100 (K3).

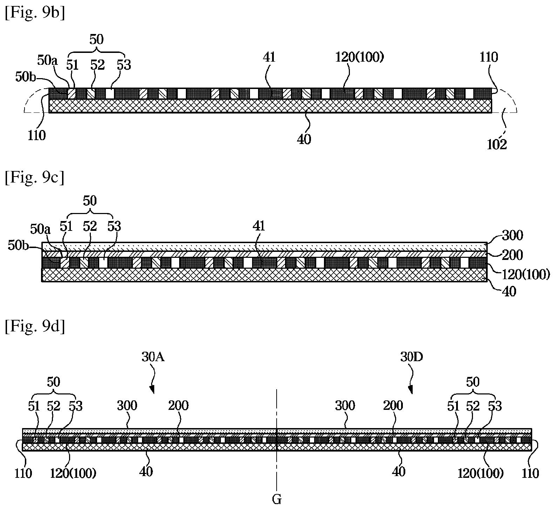

As illustrated in FIGS. 8 and 9B, the manufacturing method of the display apparatus 1 may further include forming an assembly surfaces 110 of the plurality of unit modules 30A-30L by cutting a spare portion 102 of the black molding layer 100 that is placed out of the substrate 40 (K4). The assembly surfaces 110 of the plurality of unit modules 30A-30L may be flat.

As illustrated in FIGS. 8 and 9C, the manufacturing method of the display apparatus 1 further includes arranging the transparent molding layer 200 on the black molding layer 100 (K5).

As illustrated in FIGS. 8 and 9C, the manufacturing method of the display apparatus 1 further includes arranging the black optical film 300 on the transparent molding layer 200 (K6).

As illustrated in FIGS. 8 and 9D, the manufacturing method of the display apparatus 1 further includes assembling the plurality of unit modules 30A-30L such that the respective assembly surfaces 110 faces each other (K7). Assembling the plurality of unit modules 30A-30L to be adjacent to each other may include arranging a plurality of unit modules 30A-30L in a matrix form. A seam G is formed between the plurality of the unit modules 30A-30L assembled with each other, but the light generated from the plurality of inorganic light emitting diodes 50 is blocked by the black molding layer 100 covering the side surfaces 50b of the inorganic light emitting diodes 50 and thus the seam G may be not seen from the outside of the display apparatus 1. That is, without a separate process for removing the seam G between the plurality of the unit modules 30A-30L, it is possible to prevent the seam G from being conspicuous to a user.

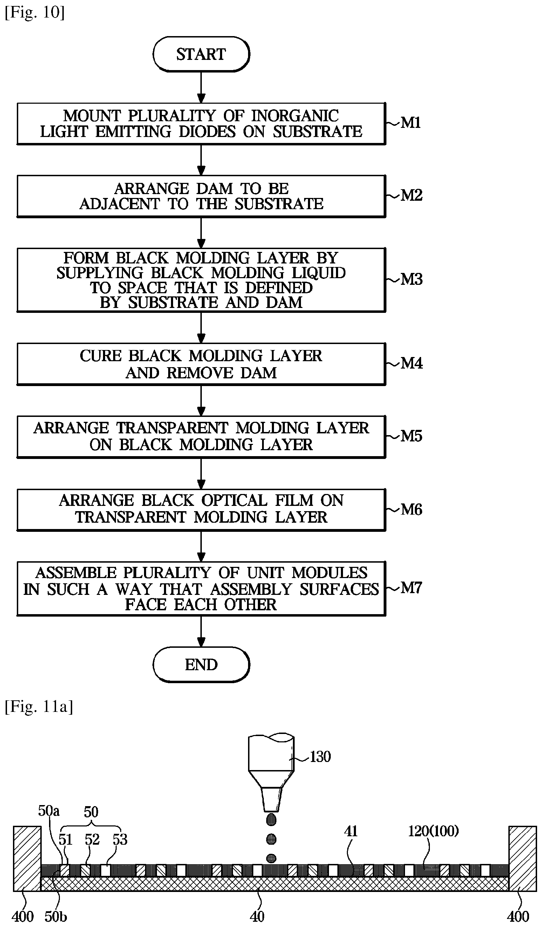

FIG. 10 is a flow chart illustrating a fourth manufacturing method of the display apparatus according to an embodiment of the invention and FIGS. 11A to 11D are views illustrating a manufacturing process according to the fourth manufacturing method of FIG. 10. The fourth manufacturing method of the display apparatus 1 is a method of manufacturing the display apparatus 1 by assembling a plurality of unit modules 30A-30L manufactured by the first manufacturing method of the display apparatus 1. Hereinafter, for convenience of description, the plurality of unit modules 30A-30L manufactured by the first manufacturing method of the display apparatus 1 will be mainly described, but alternatively may be manufactured by the second manufacturing method of the display apparatus 1. Hereinafter, FIGS. 1 to 5E may be referred to for reference numerals not shown in FIGS. 11A to 11D. Hereinafter, a case where the unit module 30A and the unit module 30D are assembled will be described as an example.

As illustrated in FIG. 10, a manufacturing method of the display apparatus 1 includes mounting the plurality of inorganic light emitting diodes 50 on the substrate 40 (M1). In this case, the first contact electrode 58 and the second contact electrode 59 of the plurality of inorganic light emitting diodes 50 may be connected to the electrodes 42 of the substrate 40 through soldering.

As illustrated in FIGS. 10 and 11A, the manufacturing method of the display apparatus 1 may further include arranging a dam 400 to be adjacent to the substrate 40 (M2). The dam 400 may be arranged in close contact with opposite ends of the substrate 40.

As illustrated in FIGS. 10 and 11A, the manufacturing method of the display apparatus 1 further includes forming the black molding layer 100 by supplying the black molding liquid 120 to a space that is defined by the substrate 40 and the dam 400 (M3). The black molding liquid 120 is supplied on the substrate 40 in such a way that the black molding liquid 120 surrounds the side surfaces 50b of the plurality of inorganic light emitting diodes 50 and the front light emitting surfaces 50a are exposed.

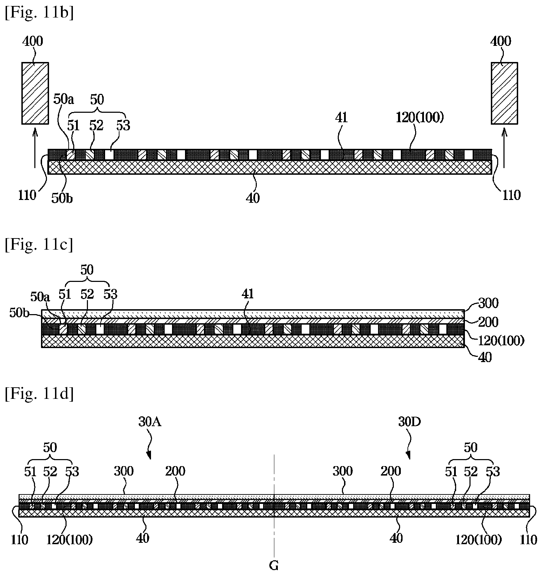

As illustrated in FIGS. 10 and 11B, the manufacturing method of the display apparatus 1 further includes curing the black molding layer 100 and removing the dam 400 (M4). The assembly surface 110 of the plurality of unit modules 30A-30L may be defined as one surface of the black molding layer 100 cured in contact with the dam 400. Therefore, the assembly surface 110 of the plurality of unit modules 30A-30L may have a shape corresponding to the dam 400. The assembly surface 110 of the plurality of unit modules 30A-30L may have a flat shape.

As illustrated in FIGS. 10 and 11C, the manufacturing method of the display apparatus 1 further includes arranging the transparent molding layer 200 on the black molding layer 100 (M5).

As illustrated in FIGS. 10 and 11C, the manufacturing method of the display apparatus 1 further includes arranging the black optical film 300 on the transparent molding layer 200 (M6).

As illustrated in FIGS. 10 and 11D, the manufacturing method of the display apparatus 1 further includes assembling the plurality of unit modules 30A-30L such that the respective assembly surfaces 110 faces each other (M7). A description thereof is the same as those shown in FIG. 5D and thus it will be omitted.

The invention is as defined in the claims.

## Claims

1. A manufacturing method of a display apparatus comprising:
mounting a plurality of inorganic light emitting diodes (50) on a mounting surface of a substrate (40), each of the plurality of inorganic light emitting diodes (50) including a side surface (50b) and a front light emitting surface (50a) that is directed to a front side of the display apparatus;
forming a black molding layer (100) having a low refractive index of 1.40 or more and 1.58 or less and configured to surround the side surface of each of the plurality of inorganic light emitting diodes (50) such that the front light emitting surface (50a) of each of the plurality of inorganic light emitting diodes (50) are exposed;
arranging a transparent molding layer (200) on the black molding layer (100) and the plurality of inorganic light emitting diodes (50) to protect the plurality of inorganic light emitting diodes;
arranging a black optical film (300) on the transparent molding layer (200) to improve optical characteristics of the plurality of inorganic light emitting diodes (50), wherein the black optical film (300) includes a neutral density film, a circularly polarizing film, and a film capable of exhibiting the black impression by using a liquid coating, and
assembling a plurality of unit modules (30A-30L) each comprising the substrate (40), the plurality of inorganic light emitting diodes (50), the black molding layer (100), the transparent molding layer (200) and the black optical film (300) to be adjacent to each other.

2. The manufacturing method of claim 1, wherein
the side surface of each of the plurality of inorganic light emitting diodes (50) is covered with the black molding layer (100).

3. The manufacturing method of claim 1, wherein
the black molding layer (100) has a refractive index of 1.40 or more and 1.51 or less.

4. The manufacturing method of claim 1, wherein
the black molding layer (100) comprises at least one of a thermosetting material and a photosensitive material.

5. The manufacturing method of claim 4, wherein
the thermosetting material comprises at least one of silicon, epoxy, ethylene-vinyl acetate copolymer (EVA), polyvinyl butyral (PVB), and urethane.

6. The manufacturing method of claim 1, wherein
a width and a length of the plurality of inorganic light emitting diodes (50) each has a size of several micrometers to several hundreds of micrometers.

7. The manufacturing method of claim 1, wherein
a first contact electrode (58) and a second contact electrode (59) of each of the plurality of inorganic light emitting diodes (50) are connected to electrodes of the substrate (40) through soldering.

8. The manufacturing method of claim 1, wherein the forming the black molding layer (100) comprises: forming the black molding layer (100) by supplying a black molding liquid onto the substrate (40); and
curing the black molding layer (100).

9. The manufacturing method of claim 1, wherein the forming the black molding layer (100) comprises:
forming the black molding layer (100) by arranging a black film on the substrate (40) to cover the plurality of inorganic light emitting diodes (50); and
allowing the black molding layer (100) to be exposed to light such that the front light emitting surfaces of the plurality of inorganic light emitting diodes (50) are exposed to outside.

10. The manufacturing method of claim 1, further comprising:
forming the black molding layer (100) to cover the substrate (40);
forming assembly surfaces (110) of the plurality of unit modules by cutting a spare portion of the black molding layer (100) that is placed out of the substrate (40); and
assembling the plurality of unit modules (30A-30L) such that the assembly surfaces (110) face each other.

11. The manufacturing method of claim 1, further comprising:
arranging a dam to be adjacent to the substrate; and
forming the black molding layer in a space that is defined by the substrate and the dam.

12. The manufacturing method of claim 13, further comprising:
curing the black molding layer;
removing the dam; and
assembling the plurality of unit modules such that assembly surfaces of the plurality of unit modules formed by the dam face each other.

13. The manufacturing method of claim 1, wherein the assembling the plurality of unit modules (30A-30L) to be adjacent to each other comprises arranging the plurality of unit modules (30A-30L) in a matrix form.

## Patentansprüche

1. Herstellungsverfahren für eine Anzeigevorrichtung, umfassend:
Montieren einer Vielzahl von anorganischen Leuchtdioden (50) auf einer Montagefläche eines Substrats (40), wobei jede der Vielzahl von anorganischen Leuchtdioden (50) eine Seitenfläche (50b) und eine vordere lichtemittierende Fläche (50a) beinhaltet, die auf eine Vorderseite der Anzeigevorrichtung gerichtet ist;
Bilden einer schwarzen Formschicht (100), die einen niedrigen Brechungsindex von 1,40 oder mehr und 1,58 oder weniger aufweist und dazu konfiguriert ist, die Seitenfläche jeder der Vielzahl von anorganischen Leuchtdioden (50) zu umgeben, sodass die vordere lichtemittierende Fläche (50a) jeder der Vielzahl von anorganischen Leuchtdioden (50) freiliegt;
Anordnen einer transparenten Formschicht (200) auf der schwarzen Formschicht (100) und der Vielzahl von anorganischen Leuchtdioden (50), um die Vielzahl von anorganischen Leuchtdioden zu schützen;
Anordnen eines schwarzen optischen Films (300) auf der transparenten Formschicht (200), um die optischen Eigenschaften der Vielzahl von anorganischen Leuchtdioden (50) zu verbessern, wobei der schwarze optische Film (300) einen Film mit neutraler Dichte, einen zirkular polarisierenden Film und einen Film umfasst, der durch Verwendung einer flüssigen Beschichtung einen schwarzen Eindruck erwecken kann, und
Montieren einer Vielzahl von Einheitsmodulen (30A-30L), die jeweils das Substrat (40), die Vielzahl von anorganischen Leuchtdioden (50), die schwarze Formschicht (100), die transparente Formschicht (200) und den schwarzen optischen Film umfassen (300), sodass diese zueinander benachbart sind.

2. Herstellungsverfahren nach Anspruch 1, wobei
die Seitenfläche jeder der Vielzahl von anorganischen Leuchtdioden (50) mit der schwarzen Formschicht (100) bedeckt ist.

3. Herstellungsverfahren nach Anspruch 1, wobei
die schwarze Formschicht (100) einen Brechungsindex von 1,40 oder mehr und 1,51 oder weniger aufweist.

4. Herstellungsverfahren nach Anspruch 1, wobei
die schwarze Formschicht (100) mindestens eines von einem duroplastischen Material und einem lichtempfindlichen Material umfasst.

5. Herstellungsverfahren nach Anspruch 4, wobei
das duroplastische Material mindestens eines von Silizium, Epoxid, Ethylen-Vinylacetat-Copolymer (EVA), Polyvinylbutyral (PVB) und Urethan umfasst.

6. Herstellungsverfahren nach Anspruch 1, wobei
eine Breite und eine Länge der Vielzahl von anorganischen Leuchtdioden (50) jeweils eine Größe von mehreren Mikrometern bis mehreren Mikrometern im dreistelligen Bereich aufweist.

7. Herstellungsverfahren nach Anspruch 1, wobei
eine erste Kontaktelektrode (58) und eine zweite Kontaktelektrode (59) jeder der Vielzahl von anorganischen Leuchtdioden (50) durch Löten mit Elektroden des Substrats (40) verbunden sind.

8. Herstellungsverfahren nach Anspruch 1, wobei das Bilden der schwarzen Formschicht (100) Folgendes umfasst: Bilden der schwarzen Formschicht (100) durch Zuführen einer schwarzen Formflüssigkeit auf das Substrat (40); und
Aushärten der schwarzen Formschicht (100).

9. Herstellungsverfahren nach Anspruch 1, wobei das Bilden der schwarzen Formschicht (100) Folgendes umfasst:
Bilden der schwarzen Formschicht (100) durch Anordnen eines schwarzen Films auf dem Substrat (40), um die Vielzahl von anorganischen Leuchtdioden (50) zu bedecken; und
Zulassen, dass die schwarze Formschicht (100) gegenüber Licht freiliegt, sodass die vorderen lichtemittierenden Flächen der Vielzahl von anorganischen lichtemittierenden Dioden (50) nach außen freigelegt werden.

10. Herstellungsverfahren nach Anspruch 1, ferner umfassend:
Bilden der schwarzen Formschicht (100), um das Substrat (40) zu bedecken;
Bilden von Montageflächen (110) der Vielzahl von Einheitsmodulen durch Ausschneiden eines überschüssigen Abschnitts der schwarzen Formschicht (100), der außerhalb des Substrats (40) platziert wird; und
Montieren der Vielzahl von Einheitsmodulen (30A-30L), sodass die Montageflächen (110) einander zugewandt sind.

11. Herstellungsverfahren nach Anspruch 1, ferner umfassend:
Anordnen einer Eindämmung, sodass diese benachbart zu dem Substrat ist; und
Bilden der schwarzen Formschicht in einem Raum, der durch das Substrat und die Eindämmung definiert ist.

12. Herstellungsverfahren nach Anspruch 13, ferner umfassend:
Aushärten der schwarzen Formschicht;
Entfernen der Eindämmung; und
Montieren der Vielzahl von Einheitsmodulen, sodass die Montageflächen der Vielzahl Einheitsmodulen, die durch die Eindämmung gebildet sind, einander zugewandt sind.

13. Herstellungsverfahren nach Anspruch 1, wobei das Montieren der Vielzahl von Einheitsmodulen (30A-30L), sodass diese benachbart zueinander sind, Anordnen der Vielzahl von Einheitsmodulen (30A-30L) in einer Matrixform umfasst.

## Revendications

1. Procédé de fabrication d'un appareil d'affichage comprenant :
le montage d'une pluralité de diodes électroluminescentes inorganiques (50) sur une surface de montage d'un substrat (40), chacune de la pluralité de diodes électroluminescentes inorganiques (50) comprenant une surface latérale (50b) et une surface électroluminescente avant (50a) qui est dirigée vers un côté avant de l'appareil d'affichage ;
la formation d'une couche de moulage noire (100) comportant un faible indice de réfraction supérieur ou égal à 1,40 et inférieur ou égal à 1,58 et configurée pour entourer la surface latérale de chacune de la pluralité de diodes électroluminescentes inorganiques (50) de sorte que la surface électroluminescente avant (50a) de chacune de la pluralité de diodes électroluminescentes inorganiques (50) soit exposée ;
la disposition d'une couche de moulage transparente (200) sur la couche de moulage noire (100) et la pluralité de diodes électroluminescentes inorganiques (50) de manière à protéger la pluralité de diodes électroluminescentes inorganiques ;
la disposition d'un film optique noir (300) sur la couche de moulage transparente (200) de manière à améliorer les caractéristiques optiques de la pluralité de diodes électroluminescentes inorganiques (50), ledit film optique noir (300) comprenant un film de densité neutre, un film de polarisation circulaire et un film pouvant présenter l'impression noire à l'aide d'un revêtement liquide, et
l'assemblage d'une pluralité de modules unitaires (30A à 30L) comprenant chacun le substrat (40), la pluralité de diodes électroluminescentes inorganiques (50), la couche de moulage noire (100), la couche de moulage transparente (200) et le film optique noir (300) de manière à être adjacents les uns aux autres.

2. Procédé de fabrication selon la revendication 1,
ladite surface latérale de chacune de la pluralité de diodes électroluminescentes inorganiques (50) étant recouverte de la couche de moulage noire (100).

3. Procédé de fabrication selon la revendication 1,
ladite couche de moulage noire (100) comportant un indice de réfraction supérieur ou égal à 1,40 et inférieur ou égal à 1,51.

4. Procédé de fabrication selon la revendication 1,
ladite couche de moulage noire (100) comprenant au moins un matériau parmi un matériau thermodurcissable et un matériau photosensible.

5. Procédé de fabrication selon la revendication 4,
ledit matériau thermodurcissable comprenant au moins un élément parmi le silicium, un époxy et le copolymère éthylène-acétate de vinyle (EVA), le polyvinylbutyral (PVB) et un uréthane.

6. Procédé de fabrication selon la revendication 1,
la largeur et la longueur de la pluralité de diodes électroluminescentes inorganiques (50) comportant chacune une taille de plusieurs micromètres à plusieurs centaines de micromètres.

7. Procédé de fabrication selon la revendication 1,
une première électrode de contact (58) et une seconde électrode de contact (59) de chacune de la pluralité de diodes électroluminescentes inorganiques (50) étant connectées aux électrodes du substrat (40) par soudure.

8. Procédé de fabrication selon la revendication 1, ladite formation de la couche de moulage noire (100) comprenant :
la formation de la couche de moulage noire (100) en fournissant un liquide de moulage noir sur le substrat (40) ; et
le durcissement de la couche de moulage noire (100).

9. Procédé de fabrication selon la revendication 1, ladite formation de la couche de moulage noire (100) comprenant :
la formation de la couche de moulage noire (100) en disposant un film noir sur le substrat (40) de manière à recouvrir la pluralité de diodes électroluminescentes inorganiques (50) ; et
le fait de permettre à la couche de moulage noire (100) d'être exposée à la lumière de sorte que les surfaces électroluminescentes avant de la pluralité de diodes électroluminescentes inorganiques (50) soient exposées à l'extérieur.

10. Procédé de fabrication selon la revendication 1, comprenant en outre :
la formation de la couche de moulage noire (100) de manière à recouvrir le substrat (40) ;
la formation de surfaces d'assemblage (110) de la pluralité de modules unitaires en découpant une partie de rechange de la couche de moulage noire (100) qui est placée hors du substrat (40) ; et
l'assemblage de la pluralité de modules unitaires (30A à 30L) de sorte que les surfaces d'assemblage (110) se fassent face.

11. Procédé de fabrication selon la revendication 1, comprenant en outre :
la disposition d'une digue de manière à ce qu'elle soit adjacente au substrat ; et
la formation de la couche de moulage noire dans un espace qui est défini par le substrat et la digue.

12. Procédé de fabrication selon la revendication 13, comprenant en outre :
le durcissement de la couche de moulage noire ;
la suppression de la digue ; et
l'assemblage de la pluralité de modules unitaires de sorte que les surfaces d'assemblage de la pluralité de modules unitaires formés par la digue se fassent face.

13. Procédé de fabrication selon la revendication 1, ledit assemblage de la pluralité de modules unitaires (30A à 30L) de manière à ce qu'ils soient adjacents les uns aux autres comprenant l'agencement de la pluralité de modules unitaires (30A à 30L) sous une forme matricielle.
